# EUROPEAN PATENT SPECIFICATION

(11) **EP 1 214 868 B1**
(45) Date of publication and mention of the grant of the patent: **12.01.2011**
(21) Application number: 00962419.8
(22) Date of filing: 31.08.2000
(51) Int. Cl.: H05B 33/10, G02F 1/1335

(54) **ORGANIC ELECTROLUMINESCENT DEVICE AND PRODUCTION METHOD THEREOF**
ORGANISCHE ELEKTROLUMINESZENTE VORRICHTUNG UND VERFAHREN ZU DERER HERSTELLUNG
DISPOSITIF ORGANIQUE ELECTROLUMINESCENT ET PROCEDE DE PRODUCTION ASSOCIE

(30) Priority: 01.09.1999 US 388273
(43) Date of publication of application: 19.06.2002
(73) Proprietor: OSRAM Opto Semiconductors GmbH, 93055 Regensburg (DE)
(72) Inventor: SIMMERER, Jürgen, 82256 Fürstenfeldbruck (DE); KLAUSMANN, Hagen, 80999 München (DE); ROGLER, Wolfgang, 91096 Möhrendorf (DE); GÜNTHER, Ewald, Maplewoods 589630, Singapore (SG); NGUYEN, Francis, Millbrae, CA 94030 (US); PAKBAZ, Hash, Oakland, CA 94619 (US)
(74) Representative: Epping - Hermann - Fischer
(86) International application number: PCT/EP2000/008520
(87) International publication number: WO 2001/017319

(56) References cited:
- EP-A- 1 018 857
- WO-A-98/03042

## Description

### Background of the Invention:

### Field of the Invention:

The invention relates to electroluminescent devices, such as displays and light sources, and to a method of producing such electroluminescent devices. More specifically, the invention pertains to flat panel displays and displays with electroluminescent organic light-emitting diodes (OLED displays).

Displays play a central role in modern electronics and they represent a key element in operator-machine interaction and communication. In keeping with both the economic and technological significance, numerous different display technologies have been developed. An increasing trend toward flat panel displays has become noticeable worldwide over the last few years. In particular, flat panel displays have recently become favored over conventional cathode ray tube (CRT) displays, which are used, for instance, in conventional monitors and television sets. A primary advantage of the flat panel display is its substantially reduced size (depth) and its extremely low power consumption.

The field of flat panel display devices is currently dominated by liquid crystal displays (LCDs). LCDs are suitable for covering the entire required spectrum in terms of chromaticity (monochrome, multi-color, full-color), size (watch faces, cell phone and mobile phone displays, personal organizers, notebooks, LCD monitors) and resolution (from seven-segment displays up to high-resolution computer monitors).

While the field of LCD displays has come a long way in only a few years, these displays are still quite restricted in terms of contrast, brightness, and viewing angle. Response times and screen update speed is also a problem, particularly at low ambient temperatures.

Further flat-panel display developments such as plasma displays have so far been able to establish themselves in niche applications only, owing to technical difficulties or because of the high price or the lack in color ability (vacuum fluorescent displays).

A promising recent development in flat panel display technology are the so-called organic light-emitting diodes (OLEDs). They offer numerous advantages in comparison to the above-mentioned technologies. OLEDs exhibit superb contrast and brightness, due to the principle of self-emissivity; low power consumption, due to small driver voltages and the lack of a necessity for back-lighting; wide viewing angle, without restrictions; and beautiful color brilliancy, again due to the principle of self-emissivity. Furthermore, these advantageous features are achieved even in the "passive" drive mode, i.e. the use of thin film transistors (as in LCD active-matrix displays), whose fabrication is complicated, is unnecessary for low and moderate pixel numbers. This fact has a beneficial effect, in particular, on the fabrication costs of OLED displays.

The publication WO 98/03042 discloses an organic electroluminescent device and a method of manufacturing such a device. By patterned exposure of an alkylatable-compound-containing organic layer of the device to an alkylating agent, a device is obtained which, in operation, exhibits patterned licht emission, without it being necessary to structure the electrode layers. A further organic electroluminescent device is also known from EP0704436.

The terms "organic light-emitting diode," "electroluminescence," "electroluminescent device," "polymer LED" and related items are used throughout this specification without specific regard to the individual nature of the photon-emitting excited state. In other words, light emission which originates from electrophosphorescence, for example, is explicitly included within the scope of the invention.

Before delving into the details of the instant invention, the following text will provide a general description of the construction of display devices based on organic light-emitting diodes (OLEDs). Express reference is thereby had to pertinent prior art disclosures which describe common features such as layer sequences and material selection. See, for example, J. Salbeck, Electroluminescence with Organic Compounds, Ber. Bunsenges. Phys. Chem. 100, p. 1667-77 (1996).

The key components used in conventional OLED configurations are as follows:

### Substrate:

A majority of the prior art systems utilize glass plates as the substrate. Instead of glass substrates, however, plastic substrates or flexible polymer films can also be used. Suitable materials are known to those skilled in the art (such as, for example, poly(ethylene terephthalate)).

### Hole-Injection Electrode:

This electrode injects preferentially positive charges ("holes") into the adjoining organic layer. The preferred materials are transparent and semitransparent electrode materials such as, for example, indium tin oxide.

### Organic Layer:

At least one organic layer is provided. A fundamental distinction to be made with the organic layers is that between OLEDs comprising monomers ("small functional molecules") and those comprising oligomers, polymers and mixtures (polymer LEDs) thereof. Where appropriate, further inorganic or organic auxiliaries such as, for instance, stabilizers may be present.

Typical OLED systems are implemented with the following layer sequence:
At least one layer which preferentially transports positive electric charges ("holes"). If required, more than one hole transport layer may be present. Exemplary materials are: copper phthalocyanine (monomer), N,N,N',N'-tetraphenylbenzidine (monomer), or poly(N-vinylcarbazole) (polymer), polyaniline (polymer) or substituted polythiophenes (polymer).

At least one preferentially light-emitting layer ("emitter layer"). The layer preferably comprises mixtures of dyes (monomers such as rubrene in tris-(8-hydroxyquinolinolato) aluminum (III) (alq), monomers in polymers (rubrene in poly(N-vinylcarbazole)) or polymer blends (poly(benzothiadiazole) in poly(9,9'-bis-alkylfluorene)).

At least one layer which preferentially transports negative electric charges ("electrons"). Examples to be mentioned are: alq (monomer), 4-(tert.-butylphenyl)-biphenylyloxadiazole in polystyrene (monomer in polymer), poly(9,9'-bis-alkylfluorene) (polymer).

Where appropriate, a number of functions (electron transport, hole transport, light emission) may be combined in a single layer. The state of the art has even introduced configurations in which all functions are combined in a single organic layer (example: poly(p-phenylenevinylene), PPV).

### Electron-Injection Electrode:

This electrode preferentially injects negative charges ("electrons") into the adjoining organic layer. The preferred materials in this context are metals having a low work function or alloys thereof or with other metals. Examples to be mentioned are: magnesium, alloy of magnesium and silver (90:10 at%), calcium, alloy of calcium and silver (90:10 at%).
Also known is the use of thin buffer layers in conjunction with metals (for example a layer having a thickness of from 0.5 to 1 nm made of lithium fluoride or silicon oxide, followed by aluminum).

### Enclosure/Encapsulation:

The preferred materials and configurations are those which offer protection against mechanical stress-induced damage and protection against moisture (water) and/or atmospheric oxygen.

Various processes have become known for the application of the organic layer(s). The following provides a brief overview of the pertinent fabrication methods:

### Oligomers/Polymers:

Liquid-phase processes are preferred in the context of oligomer and polymer materials. The most important methods known are spin coating and casting methods (doctor blading). The relevant prior art is described, for instance, in the applications U.S. Patent No. 5,247,190 to Friend et al. and European Patent Specification EP 0 573 549 B1. If a number of layers are applied successively by liquid-phase processes, care should be taken, where required, in selecting the solvent to ensure that when subsequent layers are applied, the underlying layers do not peel off in part or in their entirety. Effects due to "intermixing" (partial dissolution with subsequent diffusion) should likewise be avoided.

### Monomers:

Thermal vapor deposition processes in high vacuum are preferred in the context of monomers ("small functional molecules"). The essential factor to be considered in this case is the vapor deposition rate. By setting suitable vapor deposition rates it is possible to prepare mixtures of two materials by thermal evaporation from two vapor deposition sources controlled independently of one another. By employing suitable masks it is quite possible, using evaporable low molecular weight compounds, to fabricate patterned layers.

All of the above-noted fabrication methods dealing with the application of polymers or oligomers suffer from the drawback that, by means of the methods described via liquid phase processes, patterned layers or a number of layers of different materials next to one another either cannot be applied at all or only at disproportionate cost. The novel method according to the instant invention is particularly directed to the application of polymers or oligomers.

Spin coating is currently the most commonly used method for applying polymer layers in OLED fabrication. Like doctor blading, however, it does not offer a problem solution, since that method does not enable any selective, i.e. spatially resolved, application of the organic layer(s) in OLEDs.

Following full-surface (i.e. not spatially resolved) spin coating or doctor blading it is necessary for the organic layers to be removed in specific zones such as, for example, the contact pads or the edges for holding the cover in position during encapsulation. Processes which are known for this purpose include the mechanical removal by scraping, removing by wiping with solvent-impregnated absorbent media, and so-called laser ablation. Firstly, the removal is expensive. Secondly, those processes provide for extremely low process stability and high waste, which means that in high-volume mass production they will result in reduced yields and are therefore unsuitable.

While ink jet printing (see, for example, international publication WO 98/289046) does, in principle, permit spatially resolved application of organic layers in OLEDs, it does at the same time have some significant disadvantages. In ink jet printing, a large number of small spots are printed successively, leading to significantly longer production times. The presence of a large number of juxtaposed spots moreover entails the risk of "pinholes" being formed: incomplete surface coverage results in inhomogeneities in the organic layers which manifest themselves at least in reduced performance and reduced service life of the components fabricated therewith, but in the extreme case may lead to malfunctioning or premature failure of the component. Moreover, ink jet printing onto three-dimensionally shaped bodies ("body printing") suffers from significant or insoluble technical problems (in particular mechanical guidance of the print head or of the substrate to be printed).

Screen printing likewise enables the spatially resolved application of organic layers. It does present problems, however, in printing uneven (3-D shaped) surfaces, since there is the risk of damage to the fine printing screens. Moreover, the resolutions achievable with ink jet printing and screen printing are inadequate for the fill factors of > 80% required for high-resolution pixeled displays.

The known methods of ink jet printing, screen printing and stencil printing are considered unsuitable. The last-mentioned methods are primarily suitable for transferring thick layers (typically a few microns thick) of high-viscosity media ("pastes"), whereas ink jet printing in all its embodiments is unable to meet the condition of "simultaneous all-over application." Instead, this method sequentially, i.e. successively, covers small sub-areas. This entails drawbacks in terms of fabrication times and in terms of completeness of coverage (risk of pinholing).

The laser ablation method, in particular, is disadvantageous in that it exposes the substrate to thermal stress and that the active electroluminescent layers are subject to contamination with ablated reaction products. In the case of pixeled multicolor display devices there is the additional point that the non-emitting interspace between individual pixels should be kept as small as possible (a few micrometers), to ensure a high fill factor (proportion of the emitting areas in relation to the overall area of the display device). A non-emitting interspace in an order of magnitude of 20 µm should be aimed for, but cannot be achieved cost-effectively by means of laser ablation.

### Summary of the Invention:

It is accordingly an object of the invention to provide a fabrication method for an organic electroluminescent device with one or more patterned organic layers, which overcomes the above-mentioned disadvantages of the heretofore-known devices and methods of this general type and which provides for the more efficient and economic formation particularly of multicolor display devices with thin layers of organic materials from solutions of polymers or oligomers of suitable viscosity.

With the foregoing and other objects in view there is provided, in accordance with the intention, a method of producing an electroluminescent device is claimed as in appended claims 1 to 6.

With the above and other objects in view there is also provided, in accordance with the invention, an electroluminescent device as claimed in appended claims 7 to 10. The size of individual pixels may be as large as several hundred square cm. Such large-area organic electroluminescent devices can be used for illumination purposes such as interior lighting or dashboard lighting in automotive applications. Preferred embodiments are thin (< 2 mm) multicolor light sources.

The invention is thus based on the premise that the fabrication of organic electroluminescent systems can be achieved particularly advantageously by employing planographic printing methods ("areal printing methods"). For the purpose of the invention, planographic printing methods are those printing methods in which the material to be printed is applied simultaneously as an all-over organic layer. Such printing methods are particularly suitable for applying thin layers of organic materials from solutions of polymers or oligomers of suitable viscosity.

The invention is directed to all direct and indirect printing methods which meet the above-mentioned conditions (planographic printing, thin layers, low viscosity). For example, the invention makes use of known printing techniques such as offset printing, dry offset printing, and pad printing method (in each case in all their known embodiments).

Studies have shown that offset printing (planography, lithographic printing) in particular is a suitable method for use in building up electroluminescent arrangements to generate patterns (>> 50 µm) and layer thickness (50-500 nm) and with compliant homogeneity in terms of thickness and surface. Letterpress printing methods or intaglio printing methods can also be used successfully, however. The detailed description of the exemplary embodiments, supra, explains the use of a printing press which is typically used in LCD fabrication. There, for example, polyimide layers are directly printed in patterned form.

In typical offset printing processes, the printing medium (in the case of the invention a polymer solution or oligomer solution of suitable viscosity) is applied homogeneously in a thin film from a reservoir (the "pan" or the "well") to a transfer medium (roller). The roller transfers the polymer to a second steel roller carrying the printing pattern (produced via lithographic processes). In the lithographic processes normally used in offset printing, hydrophilic and hydrophobic zones are generated on the roller, which ensure that only the hydrophobic zones are wetted when the printing medium is applied, whereas the hydrophilic zones remain free from organic materials. The printing pattern thus generated by means of the printing medium is transferred to a so-called rubber roller, i.e. a roller with a soft plastic covering (usually silicone), which transfers the ink to the substrate. A printing press suitable for printing thin layers is described, for example, in U.S. Patent No. 4,841,857 to Hashimura et al..

In offset printing, the hydrophilic zones on the roller or plate carrying the printing pattern are usually covered with water vapor. This causes the hydrophobic polymer solution to be repelled, whereas the hydrophobic zones are coated with the polymer solution. With this method it is not possible, however, to preclude the risk of moisture being introduced by emulsification when electroluminescent polymers are being printed, thus impairing the performance of the OLED displays. Particularly suitable for the fabrication of electroluminescent configurations are therefore two modified variations on offset printing, which do not require water vapor for separating inked and uninked regions.

One of these methods corresponds to the one described in U.S. Patent No. 4,841,857, except that the roller (block) carrying the printing pattern is coated with a hydrophobic material, usually silicone, and the printing pattern corresponds to the silicone-free zones on the roller surface. The silicone-coated areas have the effect of repelling the polymer solution, which in contrast is adsorbed on the silicone-free areas and is transferred to the second plastic-coated roller. The printing medium is thereby transferred to the substrate in the lithographically predefined pattern. A process that is suitable for processing electroluminiscent (EL) polymers in the course of the fabrication of OLED displays is described in Japanese Journal of Applied Physics 30, 11B, pp. 3313-17 (1991) (application of 15-20 µm structures in LCD technology).

Pad printing is a further method particularly suitable for printing EL polymers during the fabrication of OLEDs. At the core of this method is a printing plate (block) carrying the pattern to be printed, which has been generated on the surface by means of lithographic methods known to those skilled in the art. Said plate is usually made of steel, although plastic plates are likewise possible. Application of the printing medium (polymer solution or oligomer solution) is effected either by pouring from a reservoir or by means of a roller coated with the printing medium. Then a doctor blade is used to strip off excess printing medium. The printing pattern coated with printing medium is then transferred to a pad made of flexible material, by the pad being pressed onto the printing plate under slight pressure. Pads are usually made of silicone elastomer or polyurethane elastomer which must have suitable flexibility. Usually, the pad is of conical shape in its bottom section, so that it will come to lie flat against the block surface when a suitable pressure is applied and will accept the printing medium true to size. The accepted pattern is then transferred true to size by the pad to the substrate. The mechanical properties of the pad and the consistency of the printing medium are decisive for printing quality. Owing to the flexibility of the transfer pad, pad printing is particularly suitable for printing uneven surfaces and thus for applying thin organic layers to three-dimensional shaped substrates. The process was described in detail by Hahne et al. in "Pad Printing - A Novel Thick-Film Technique of Fine-Line Printing for Solar Cells," presented at the 2nd World Conf. and Exh. on Photovoltaic Solar Energy Conversion, Vienna, July 1998.

Suitable for the fabrication according to the invention of OLEDs by means of offset printing are solvent-processable functional oligomers and polymers. Examples of suitable materials include poly(phenylene vinylenes) (see international PCT publication WO 98/27136), polyfluorenes and copolymers (see international PCT publication WO 97/05184), polyphenylene amines, polycarbazoles, polyanilines and polythiophenes in suitable solvents. Examples of suitable oligomeric organic materials include oligomeric fluorene and triptycene compounds. Solutions of mixtures of suitable functional organic materials can likewise be processed in accordance with the method according to the invention.

Other features which are considered as characteristic for the invention are set forth in the appended claims.

Although the invention is illustrated and described herein as embodied in a method for fabricating OLED flat panel displays, it is nevertheless not intended to be limited to the details shown, since various modifications and structural changes may be made therein within the scope and range of equivalents of the claims.

The construction of the invention, however, together with additional objects and advantages thereof will be best understood from the following description of the specific embodiment when read in connection with the accompanying drawings.

### Brief Description of the Drawing:

Fig. 1 is a diagrammatic plan view of two-color organic light emitting diode (OLED);
Fig. 2 is a diagrammatic plan view of a multi-pixel display device.

### Description of the Preferred Embodiments:

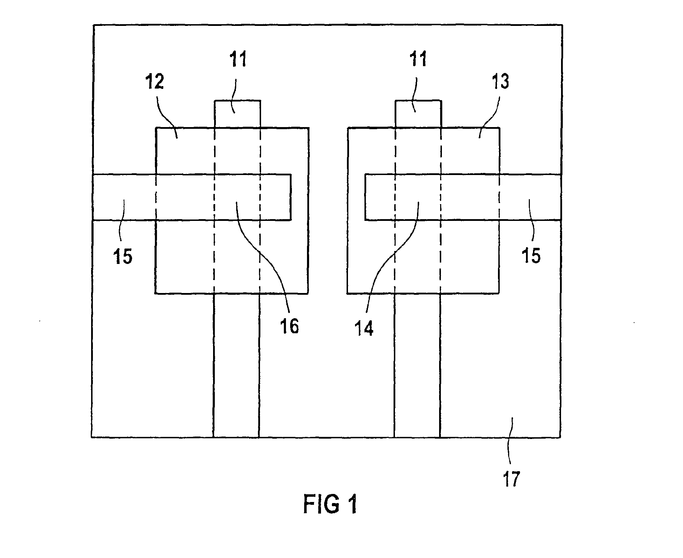

Referring now to the figures of the drawing in detail and first, particularly, to Fig. 1 thereof, there is seen a two-color organic light-emitting diode. The illustration is highly diagrammatic and it is not to scale. The configuration includes a glass substrate 17 having a size of approximately 50mm x 50mm and a thickness of 1.1 mm. Two photopatterned semitransparent strip-shaped electrodes 11 of indium tin oxide have a width of about 2 mm and are spaced apart by a gap of 1 mm. A layer 12 of poly(2-methoxy-5-(2'-ethyl-hexyloxy)-1,4-phenylenevinylene) (orange-red emitter), i.e. MEH-PPV, and a layer 13 of poly(9,9'-bis-n-octyl-fluorene-alt-2,1,3-benzothiadiazole) (green emitter), i.e. polyfluorene, are printed onto the electrodes 11 in a process according to the invention. An "active" area 14 corresponding to a light-emitting area of polyfluorene and another "active" area 16 corresponding to a light-emitting area of MEH-PPV are defined by vapor-deposited electrodes 15 of calcium/silver.

During the vapor deposition process, the metal layers are patterned in such a way with the aid of a shadow mask that two parallel strips of width 2 mm are formed. The "active," i.e. emitting, areas of the electroluminescent component fabricated as described above are defined by the overlap of the indium tin oxide electrode with the metal electrode. The active area, for both emitting areas, is 2 mm x 2 mm each.

When a voltage of 20 V (ITO positive in each case) is applied, the component fabricated as above will luminesce orange-red in the case of MEH-PPV and green in the case of the polyfluorene.

### Example 1:

The indium tin oxide (ITO) layer of an ITO coated glass substrate was patterned in such a way - by means of photolithographic methods followed by wet-chemical etching - that two strip-shaped electrodes were formed. The electrodes thus fabricated were then cleaned by means of solvents (acetone, followed by methanol, each for a period of 30 minutes in an ultrasonic bath at room temperature). Then a solution of MEH-PPV (10% strength solution in cyclohexanone) was applied by means of pad printing to one of the two ITO electrode strips. The glass substrate with the polymer layer was then dried for 30 minutes at a temperature of 60ºC. On top of the other ITO strip, a solution of 10 wt% of polyfluorene was applied by means of pad printing. Next, a layer of 150 nm of calcium was applied in high vacuum by thermal evaporation through a shadow mask, followed by a layer of 150 nm of silver (without the vacuum being broken). The base pressure was 1·10⁻⁵ mbar, the vapor deposition rate for both metal layers was 1 nm/s in each case.

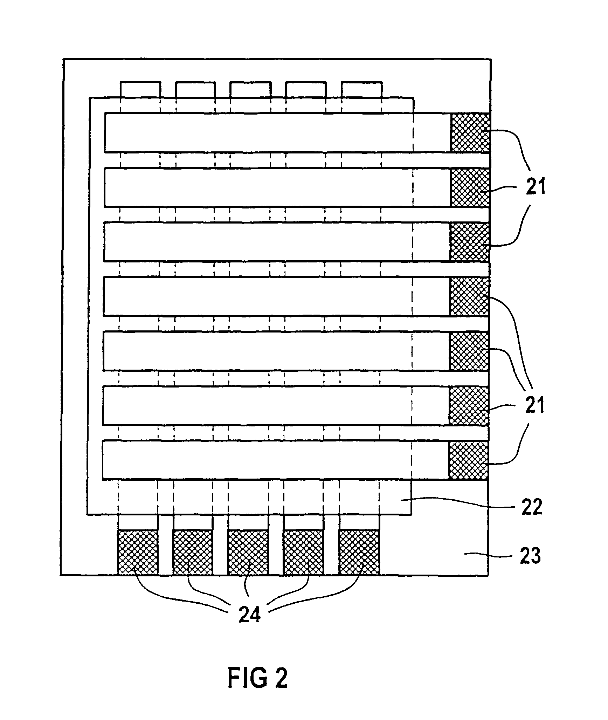

Referring now to Fig. 2, there is shown a diagrammatic plan view onto a 5 x 7 dot matrix display formed by a matrix of organic electroluminescent LEDs. Metal electrodes 21 form the matrix rows of the display, and the contact pads for the electrodes are indicated by the darkened zones on the righthand side. Area 22 is printed with active electroluminescent polymer on the underlying glass substrate 23. Semitransparent electrodes 24 of indium tin oxide form the columns of the matrix display. The contact pads of the ITO electrodes 24 are indicated by the darkened zones on the bottom of Fig. 2.

### Example 2:

This example corresponds to the embodiment illustrated in Fig. 2. An indium tin oxide (ITO) layer was deposited onto a glass substrate (size 50 mm x 50 mm, thickness 1.1 mm) and patterned in such a way - by means of photolithographic methods followed by wet-chemical etching - that five mutually parallel, strip-shaped electrodes were formed. The electrodes were patterned to a width of 0.3 mm and to a spacing gap of 0.1 mm. The transparent electrodes thus fabricated were then cleaned using solvents (acetone, followed by methanol, for a period of 30 minutes each in an ultrasonic bath at room temperature). Then a solution of MEH-PPV (20% strength solution in cyclohexanone) was applied by means of pad printing. The areas intended for contact pads remained uncovered. The configuration was then dried for 30 minutes at a temperature of 60ºC. Then a layer of 150 nm of calcium was applied in high vacuum by thermal evaporation, followed by a layer of 150 nm of silver (without the vacuum being broken). The base pressure was 1·10⁻⁵ mbar and the vapor deposition rate for both metal layers was 1 nm/s in each case.

During the vapor deposition process, the metal layers were patterned in such a way with the aid of a shadow mask that seven strips of width 0.3 mm and a spacing gap of 0.1 mm were formed. The "active," i.e. emitting, area of the electroluminescent component fabricated as described was defined by the overlap of the indium tin oxide electrodes with the metal electrodes. In total, 5 x 7 = 35 pixels are present, which form a matrix-type display.

When a voltage of 20 V (ITO positive) is applied, the component fabricated as above will luminesce orange-red. Known methods (anisotropic conductive adhesives, bonding) can be used to make contact with the component, without partial removal of the active polymer film being required.

### Example 3:

A glass substrate (size 400 mm x 350 mm, thickness 1.1 mm) was coated with an indium tin oxide (ITO) layer and patterned in such a way - by means of photolithographic methods followed by wet-chemical etching - that a multiplicity of mutually parallel, strip-shaped electrodes of 2 mm width and a gap spacing of 1 mm are formed. The electrodes thus fabricated are then cleaned using solvents (acetone, followed by methanol, for a period of 30 minutes each in an ultrasonic bath at room temperature). Then an aqueous solution of poly(ethylene-dioxythiophene) (PEDOT) was applied by means of rotary letterpress printing. The shear viscosity of the solution was 80 cPs at room temperature (measured at a shear rate of 10 s⁻¹). The solution was applied continuously (1 ml/min) to a silicone-coated roller (blanket roller or rubber roller) having a width of about 500 mm and a diameter of about 15 cm. The roller was mounted horizontally and rotated at 0.5 revolutions/s. A steel roller of similar width and a diameter of about 30 cm rotated in parallel to the silicone roller. The surface of the steel roller was formed with a dense arrangement of small holes (depth < 0.2 mm, diameter < 0.05 mm). With the aid of a suitably adjusted gap (< 0.1 mm) between the silicone roller and the steel roller, a homogeneous, thin film of the printing medium, in this case PEDOT, was formed on the latter. To transfer the pattern, a photopatternable elastomer material was used. Such elastomers are commercially available.

Any conventional lithographic processes are suitable for patterning plates having a thickness of about 5 mm in such a way that the zones to be printed subsequently are raised by about 1 mm (letterpress printing). The surface of the raised zones was roughened to ensure the best possible film transfer. The elastomer plate thus patterned was mounted on a suitable roller (diameter about 40 cm, conventionally referred to as a plate cylinder) which runs parallel to the film-carrying steel roller. To carry out the printing operation proper, the elastomer surface was then rolled once over the steel roller, so that the raised areas were covered uniformly with PEDOT. In the next step, the elastomer surface was rolled across the glass plate, thus transferring the PEDOT film in its patterned form. Next the film was dried for 30 minutes at 150°C. Following the foregoing parameters, a layer thickness of 15 nm was obtained.

Suitable printing presses are commercially available.

Similarly to the above examples, a layer of MEH-PPV (10% strength solution in cyclohexanone) was then applied. The glass substrate with the two polymer layers is then dried at a temperature of 60ºC for a period of 30 min. Next, a layer of 150 nm of calcium was applied in high vacuum by thermal evaporation through a shadow mask, followed by a 150 nm layer of silver (without the vacuum being broken). The base pressure was 1·10⁻⁵ mbar, and the vapor deposition rate for both metal layers was 1 nm/s in each case.

During the vapor deposition process, the metal layers were patterned in such a way with the aid of a shadow mask that two parallel strips of width 2 mm are formed. The "active," i.e. emitting, areas of the electroluminescent component fabricated as described above were defined by the overlap of the indium tin oxide ITO electrode with the metal electrode. The active area, for both emitting areas, was 2 mm x 2 mm each.

When a voltage of 20 V (ITO positive in each case) was applied, the flat panel display emitted orange-red in the case of MEH-PPV.

## Claims

1. A method of producing an electroluminescent device, which comprises the steps of:
providing a substrate (17) including an electrode (11);
printing at least one layer of electroluminescent organic material (12), (13) onto the substrate (17) by planographic printing; and
electrically contacting the layer of electroluminescent organic material (12), (13), wherein the step of contacting comprises performing a vapor deposition step, of a metal layer on the layer of electroluminescent organic material.

2. The method according to claim 1, wherein the step of printing comprises printing with a planographic printing process selected from the group consisting of pad printing, offset printing, dry offset printing, letterpress printing, and intaglio printing.

3. The method according to claim 1, which comprises the step of patterning a plurality of electrodes (11) on the substrate prior to the step of printing.

4. The method according to claim 1, wherein the step of printing of least one layer of electroluminescent organic material comprises forming a pattern of a first electroluminescent organic material (12) and a pattern of a second electroluminescent organic material (13) onto the substrate (17), whereby the pattern of the second electroluminescent organic material (13) is laterally spaced from the pattern of the first electroluminescent organic material (12).

5. The method according to claim 1, wherein the step of providing a substrate including an electrode comprises the steps of lithographically and wet-chemically patterning an ITO layer on a glass substrate (17) and forming a plurality of mutually parallel, spaced-apart, strip-shaped electrodes (11) and subsequently cleaning the electrodes (11);
the step of printing comprises printing a first layer of electroluminescent organic material (12) by printing a solution of a first electroluminescent organic material (12) onto the electrodes (11) with a planographic printing process and drying the first organic material (12), and subsequently printing a second layer of electroluminescent organic material (13) by printing a solution of a second electroluminescent organic material (13) onto the first electroluminescent organic material (12) with a planographic printing process and drying the second electroluminescent organic material (13); and
, wherein the step of contacting comprises the step of depositing by vapor deposition a plurality of electrodes (15) onto the electroluminescent organic layers (12), (13).

6. The method according to claim 1, wherein the vapor deposition step comprises vapor depositing electrodes (15) formed of a material selected from the group consisting of low work function metals, alloys comprising at least one low work function metal, and conducting oxides.

7. An electroluminescent device obtainable according to the method of anyone of claims 1 to 6, comprising:
a substrate (23);
a first plurality of patterned electrodes (21) disposed on said substrate (23);
at least one layer of electroluminescent organic material (22) printed with a planographic printing process on said first plurality of patterned electrodes (21); and
a second plurality of patterned electrodes (24) disposed by vapor deposition on said electroluminescent organic material.

8. The device according to claim 7, wherein said substrate (23) is a substantially flat glass substrate, and said first plurality of patterned electrodes (21), (24) are formed of a material selected from the group consisting of ITO, calcium, and silver.

9. The device according to claim 7, wherein said layer of electroluminescent organic material (22) is one of a plurality of layers of electroluminescent organic materials printed onto said first plurality of patterned electrodes (21) and electrically contacted with said second plurality of patterned electrodes to form a multicolor electroluminescent device, a pixeled multicolor display device, or a full-color display device.

10. The device according to claim 7, wherein said device is a display or a light source.

## Patentansprüche

1. Verfahren zur Herstellung einer elektrolumineszenten Vorrichtung, welches die folgenden Schritte aufweist:
Bereitstellen eines Substrats (17), das eine Elektrode (11) aufweist;
Drucken mindestens einer Schicht von elektrolumineszentem organischem Material (12), (13) auf das Substrat (17) durch Flachdruck; und
elektrisches Kontaktieren der Schicht von elektrolumineszentem organischem Material (12), (13), wobei der Schritt des Kontaktierens ein Durchführen eines Dampfabscheidungsschritts einer Metallschicht auf die Schicht von elektrolumineszentem organischem Material aufweist.

2. Verfahren nach Anspruch 1, wobei der Schritt des Druckens ein Drucken mit einem Flachdruckprozess aufweist, der aus der Gruppe bestehend aus Tampondruck, Offsetdruck, Trockenoffsetdruck, Hochdruck und Tiefdruck ausgewählt ist.

3. Verfahren nach Anspruch 1, welches den Schritt des Strukturierens einer Mehrzahl von Elektroden (11) auf dem Substrat vor dem Schritt des Druckens aufweist.

4. Verfahren nach Anspruch 1, wobei der Schritt des Druckens mindestens einer Schicht von elektrolumineszentem organischem Material ein Bilden einer Struktur eines ersten elektrolumineszenten organischen Materials (12) und einer Struktur eines zweiten elektrolumineszenten organischen Materials (13) auf dem Substrat (17) aufweist, wobei die Struktur des zweiten elektrolumineszenten organischen Materials (13) seitlich von der Struktur des ersten elektrolumineszenten organischen Materials (12) beabstandet ist.

5. Verfahren nach Anspruch 1, wobei der Schritt des Bereitstellens eines Substrats, das eine Elektrode aufweist, die Schritte des lithografischen und nasschemischen Strukturierens einer ITO-Schicht auf einem Glassubstrat (17) und des Bildens einer Mehrzahl von zueinander parallelen, beabstandeten, streifenförmigen Elektroden (11) und des anschließenden Reinigens der Elektroden (11) aufweist;
wobei der Schritt des Druckens aufweist:
Drucken einer ersten Schicht von elektrolumineszentem organischem Material (12) durch Drucken einer Lösung eines ersten elektrolumineszenten organischen Materials (12) auf die Elektroden (11) mit einem Flachdruckprozess und Trocknen des ersten organischen Materials (12); und
anschließendes Drucken einer zweiten Schicht von elektrolumineszentem organischem Material (13) durch Drucken einer Lösung eines zweiten elektrolumineszenten organischen Materials (13) auf das erste elektrolumineszente organische Material (12) mit einem Flachdruckprozess und Trocknen des zweiten elektrolumineszenten organischen Materials (13); und
wobei der Schritt des Kontaktierens den Schritt des Abscheidens einer Mehrzahl von Elektroden (15) auf die elektrolumineszenten organischen Schichten (12), (13) durch Dampfabscheidung aufweist.

6. Verfahren nach Anspruch 1, wobei der Dampfabscheidungsschritt ein Dampfabscheiden von Elektroden (15) aufweist, die aus einem Material gebildet sind, das aus der Gruppe bestehend aus Metallen mit niedriger Austrittsarbeit, Legierungen, die mindestens ein Metall mit niedriger Austrittsarbeit aufweisen, und leitenden Oxiden ausgewählt ist.

7. Elektrolumineszente Vorrichtung, die gemäß dem Verfahren nach einem der Ansprüche 1 bis 6 erhalten werden kann und aufweist:
ein Substrat (23);
eine erste Mehrzahl von strukturierten Elektroden (21), die auf dem Substrat (23) angeordnet sind;
mindestens eine Schicht von elektrolumineszentem organischem Material (22), das mit einem Flachdruckprozess auf die erste Mehrzahl von strukturierten Elektroden (21) gedruckt ist; und
eine zweite Mehrzahl von strukturierten Elektroden (24), die durch Dampfabscheidung auf dem elektrolumineszenten organischen Material angeordnet sind.

8. Vorrichtung nach Anspruch 7, wobei das Substrat (23) ein im Wesentlichen flaches Glassubstrat ist, und die erste Mehrzahl von strukturierten Elektroden (21), (24) aus einem Material gebildet ist, das aus der Gruppe bestehend aus ITO, Calcium und Silber ausgewählt ist.

9. Vorrichtung nach Anspruch 7, wobei die Schicht von elektrolumineszentem organischem Material (22) eine einer Mehrzahl von Schichten von elektrolumineszenten organischen Materialien ist, die auf die erste Mehrzahl von strukturierten Elektroden (21) gedruckt und mit der zweiten Mehrzahl von strukturierten Elektroden elektrisch kontaktiert sind, um eine elektrolumineszente Mehrfarben-Vorrichtung, eine gepixelte Mehrfarben-Anzeigevorrichtung oder eine Vollfarb-Anzeigevorrichtung zu bilden.

10. Vorrichtung nach Anspruch 7, wobei die Vorrichtung eine Anzeige oder eine Lichtquelle ist.

## Revendications

1. Procédé de production d'un dispositif électroluminescent, le procédé comportant les étapes qui consistent à :
prévoir un substrat (17) qui présente une électrode (11),
par impression planographique, imprimer au moins une couche de matériau organique électroluminescent (12), (13) sur le substrat (17) et
mettre en contact électrique la couche de matériau organique électroluminescent (12), (13), l'étape de mise en contact comprenant l'exécution d'une étape de dépôt en phase vapeur d'une couche métallique sur les couches de matériau organique électroluminescent.

2. Procédé selon la revendication 1, dans lequel l'étape d'impression comprend l'impression à l'aide d'une opération d'impression planographique sélectionnée dans l'ensemble constitué de l'impression au tampon, de l'impression offset, de l'impression offset à sec, de la typographie et de l'impression en taille douce.

3. Procédé selon la revendication 1, qui comprend l'étape qui consiste à réaliser un motif constitué de plusieurs électrodes (11) sur le substrat avant l'étape d'impression.

4. Procédé selon la revendication 1, dans lequel l'étape d'impression d'au moins une couche de matériau organique électroluminescent comprend l'étape qui consiste à former sur le substrat (17) un motif en un premier matériau organique électroluminescent (12) et un motif en un deuxième matériau organique électroluminescent (13), le motif du deuxième matériau organique électroluminescent (13) étant situé à distance latérale du motif du premier matériau organique électroluminescent (12).

5. Procédé selon la revendication 1, dans lequel l'étape qui consiste à prévoir un substrat présentant une électrode comprend les étapes qui consistent à réaliser un motif par lithographie et par voie chimique en conditions humides sur une couche d'ITO d'un substrat de verre (17) et à former plusieurs électrodes (11) en forme de rubans écartés les uns des autres et mutuellement parallèles et
à nettoyer ensuite les électrodes (11), l'étape d'impression comprenant l'impression d'une première couche de matériau organique électroluminescent (12) en imprimant une solution d'un premier matériau organique électroluminescent (12) sur les électrodes (11) à l'aide d'un procédé d'impression planographique et le séchage du premier matériau organique (12) et
ensuite, l'impression d'une deuxième couche de matériau organique électroluminescent (13) en imprimant une solution d'un deuxième matériau organique électroluminescent (13) sur le premier matériau organique électroluminescent (12) à l'aide d'un procédé d'impression planographique et le séchage du deuxième matériau organique électroluminescent (13), et
l'étape de mise en contact comprenant l'étape qui consiste à déposer plusieurs électrodes (15) par dépôt en phase vapeur sur les couches organiques électroluminescentes (12), (13).

6. Procédé selon la revendication 1, dans lequel l'étape de dépôt en phase vapeur comprend le dépôt en phase vapeur d'électrodes (15) formées d'un matériau sélectionné dans l'ensemble constitué des matériaux à basse fonction de travail, d'alliages comprenant au moins un matériau à basse fonction de travail et des oxydes conducteurs.

7. Dispositif électroluminescent obtenu avec le procédé selon l'une quelconque des revendications 1 à 6, comprenant :
un substrat (23),
un premier ensemble de motifs d'électrode (21) disposé sur ledit substrat (23),
au moins une couche d'un matériau organique électroluminescent (22) imprimée à l'aide d'un procédé d'impression planographique sur ledit premier ensemble de motifs d'électrode (21) et
un deuxième ensemble de motifs d'électrode (24) déposé par dépôt en phase vapeur sur ledit matériau organique électroluminescent.

8. Dispositif selon la revendication 7, dans lequel ledit substrat (23) est un substrat de verre essentiellement plat et ledit premier ensemble de motifs d'électrode (21), (24) est formé d'un matériau sélectionné dans l'ensemble constitué de l'ITO, du calcium et de l'argent.

9. Dispositif selon la revendication 7, dans lequel ladite couche de matériau organique électroluminescent (22) est l'une parmi plusieurs couches de matériau organique électroluminescent imprimées sur ledit ensemble de motifs d'électrode (21) et mises en contact électrique avec ledit deuxième ensemble de motifs d'électrode pour former un dispositif électroluminescent multicolore, un dispositif d'affichage à pixels de plusieurs couleurs ou un dispositif d'affichage en pleine couleur.

10. Dispositif selon la revendication 7, dans lequel ledit dispositif est un affichage ou une source de lumière.
